# FASCICULE DE BREVET EUROPEEN

(11) **EP 0 554 154 B1**
(45) Date de publication et mention de la délivrance du brevet: **29.04.1998**
(21) Numéro de dépôt: 93400170.2
(22) Date de dépôt: 26.01.1993
(51) Int. Cl.: H02J 7/24

(54) **Circuit de gestion des commutations pour la commande du courant d'excitation d'un alternateur**
Verwaltungsschaltung für Erregerstromsteuervorrichtung
Switching control circuit for excitation current control device

(30) Priorité: 28.01.1992 FR 9200863
(43) Date de publication de la demande: 04.08.1993
(73) Titulaire: VALEO EQUIPEMENTS ELECTRIQUES MOTEUR, 94000 Créteil (FR)
(72) Inventeur: Pierret, Jean-Marie, F-75012 Paris (FR); Brandy, Frédéric, F-94250 Gentilly (FR)
(74) Mandataire: Martin, Jean-Jacques

(56) Documents cités:
- WO-A-92/01335
- DE-A- 3 815 842
- US-A- 4 504 779
- US-A- 4 733 159

## Description

La présente invention concerne d'une façon générale les circuits régulateurs de la tension de charge d'une batterie par un alternateur, notamment dans un véhicule automobile.

Elle concerne plus particulièrement un nouveau circuit de gestion des commutations d'un élément interrupteur prévu en série avec l'enroulement d'excitation de l'alternateur en vue de commander le courant d'excitation.

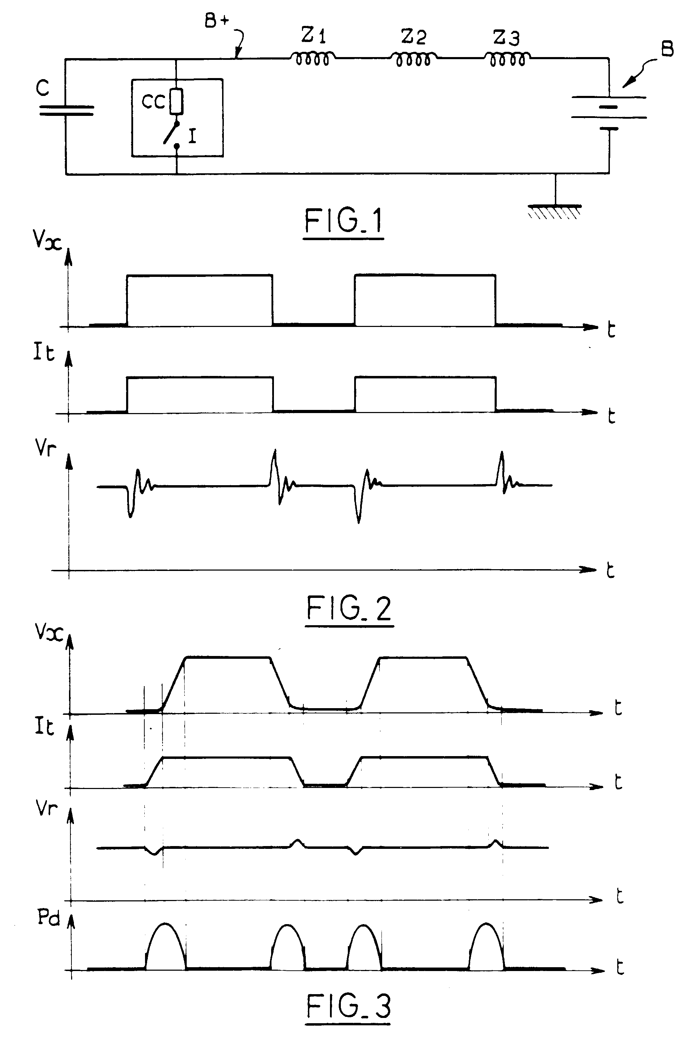

En référence à la figure 1 des dessins, on a représenté dans son ensemble un circuit électrique de véhicule automobile qui comprend une batterie B et un certain nombre de charges telles que CC commandées par des interrupteurs I. Le réseau de bord du véhicule comporte par ailleurs par nature un certain nombre d'impédances à caractère selfique notées Z1, Z2, Z3. Un condensateur d'antiparasitage C est par ailleurs conventionnellement prévu pour atténuer les tensions parasites, notamment dans le domaine des radiofréquences, qui sont produites par ces impédances lors de variations brusques du courant consommé. Ces variations brusques sont provoquées notamment par le découpage à fréquence élevée du courant d'excitation de l'alternateur, engendré par le circuit régulateur associé.

Cependant, on observe dans la pratique que le condensateur C n'est pas à même d'atténuer suffisamment ces tensions parasites.

La figure 2 montre l'apparition de telles composantes parasites dans la tension du réseau Vr à chaque interruption et rétablissement du courant It pris sur le réseau pour former le courant d'excitation.

Une solution connue à ce problème, telle que définie dans le préambule de la revendication 1, consiste à accroître les temps de montée et de descente de la tension appliquée à l'enroulement d'excitation de l'alternateur. On ralentit ainsi la vitesse de transfert du courant d'excitation entre le transistor et la diode de roue libre associée lors de l'ouverture du transistor, pour ainsi diminuer l'apparition de tensions parasites dans les radiofréquences. Ceci est réalisé classiquement en plaçant une résistance de valeur appropriée en série avec la grille d'un transistor MOS de commutation du courant d'excitation. La figure 3 illustre de haut en bas la tension d'excitation Vx (tension aux bornes de l'enroulement d'excitation), le courant It pris sur le réseau, la tension Vr du réseau et la puissance Pd dissipée dans le transistor au cours des phases de commutation. On observe que les composantes radiofréquences de la tension Vr sont effectivement diminuées. Cependant, on note également que la puissance dissipée par le circuit à chaque commutation est importante. Cette puissance dissipée croît en outre avec la fréquence des commutations, et s'avère tout à fait gênante dans le cas où le régulateur associé est du type dit à "fréquence libre" et peut donner lieu à des fréquences de commutation élevées de l'ordre de 200 à 500 Hz. Dans ce cas, la puissance dissipée par commutation peut atteindre 2 watts ou davantage.

La présente invention a pour objet de limiter les composantes parasites de haute fréquence dans la tension du réseau, sans pour autant dissiper dans le circuit des puissances importantes.

Elle concerne à cet effet un circuit régulateur, tel que défini dans la revendication 1.

Des aspects préférés de ce circuit sont définis dans les sous-revendications.

D'autres aspects, buts et avantages de la présente invention apparaîtront mieux à la lecture de la description détaillée suivante d'une forme de réalisation préférée de celle-ci, donnée à titre d'exemple non limitatif et faite en référence aux dessins annexés, sur lesquels :
la figure 1 est une vue d'ensemble schématique d'un circuit électrique de véhicule automobile,
la figure 2 illustre par une série de chronogrammes le comportement classique du circuit de la figure 1 lors de certaines commutations,
la figure 3 illustre par une autre série de chronogramme le comportement d'un circuit réalisé selon un perfectionnement connu,
la figure 4 illustre par une autre série de chronogrammes le comportement d'un circuit réalisé selon l'invention,
la figure 5 est un schéma électrique détaillé d'un premier mode de réalisation d'un circuit de gestion des commutations selon l'invention, et
la figure 6 est un schéma électrique détaillé d'un deuxième mode de réalisation d'un circuit de gestion des commutations selon l'invention.

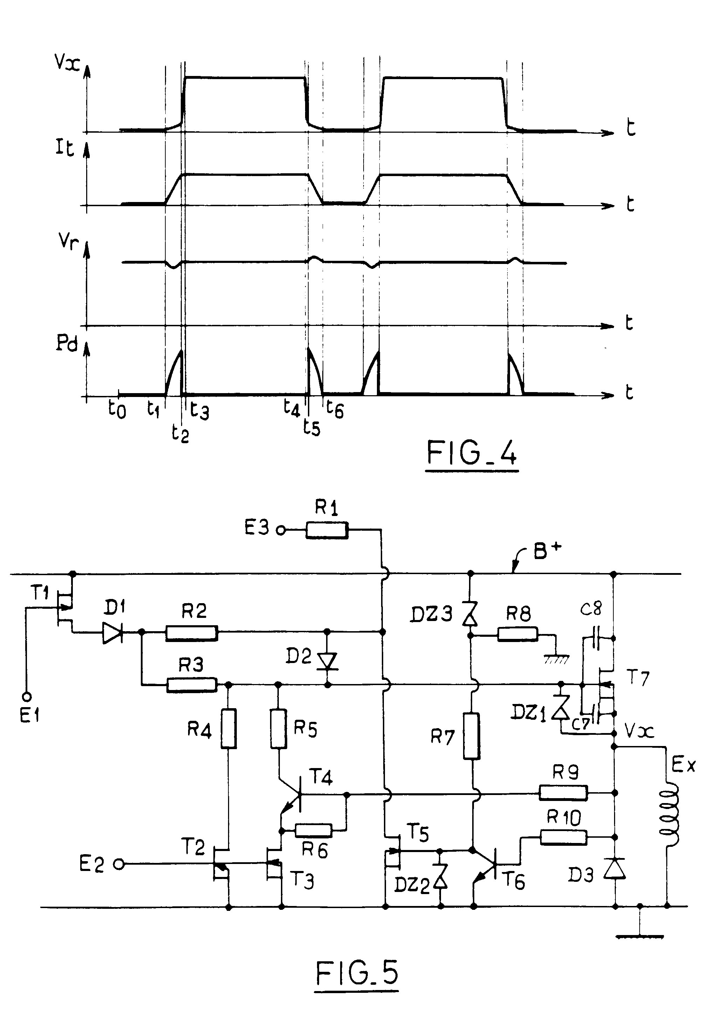

En référence à la figure 5, un circuit de gestion des commutations selon une première forme d'exécution de l'invention comprend une borne d'entrée E1 de commande d'excitation, appliquée à la grille d'un transistor MOS T1. Le drain de T1 est relié à la ligne d'alimentation B+ reliée à la tension de batterie (en l'espèce positive), et sa source est reliée à l'anode d'une diode D1. La cathode de D1 est reliée à une première borne d'une résistance R2 et à la première borne d'une résistance R3. La deuxième borne de R3 est reliée via une résistance R4 au drain d'un premier transistor T2 d'une paire de transistors MOS T2 et T3 partageant la même grille. Cette grille est reliée à une borne d'entrée E2 pour une commande d'excitation inversée ou complémentaire.

Les sources de T2 et T3 sont reliées à la masse. La deuxième borne de R3 est également reliée via une résistance R5 au collecteur d'un transistor bipolaire NPN T4 dont l'émettteur est relié au drain de T3. Une résistance R6 est montée entre la base de T4 et son émetteur.

La deuxième borne de R2 est reliée d'une part à l'anode d'une diode D2 et d'autre part à une deuxième borne d'une résistance R1 dont la première borne est reliée à une borne d'entrée E3 destinée à recevoir des signaux d'un circuit dit de pompe de charge.

La cathode de D2 est reliée au point commun entre R3, R4 et R5, lui-même relié à la grille d'un transistor MOS de puissance T7.

La deuxième borne de R1 est en outre reliée au drain d'un transistor MOS T5 dont la source est à la masse et dont la grille est reliée au collecteur d'un transistor bipolaire NPN T6. Une diode zéner DZ2 est montée entre ladite grille de T5 et la masse. L'émetteur de T6 est à la masse, tandis que sa base est reliée via une résistance R10 à la source de T7. Le collecteur de T6 et la grille de T5 sont reliés à la ligne B+ via, dans l'ordre, une résistance R7 et une diode zéner DZ3. Le point commun entre R7 et DZ3 est relié à la masse via une résistance R8.

La base du transistor T4 précité est reliée à la source de T7, via une résistance R9. La source de T7 est par ailleurs reliée à la cathode d'une diode de roue libre D3 dont l'anode est à la masse.

Le drain de T7 est relié à la ligne B+, et une diode zéner DZ1 est montée entre la grille et la source de T7.

L'enroulement d'excitation Ex de l'alternateur est relié entre la source de T7 et la masse. La tension à ses bornes est notée Vx. Les capacités de grille de T7 sont indiquées en C7 et C8.

Le circuit dit "pompe de charge" (non représenté), dont la sortie est appliquée à l'entrée E3, est de façon connue en soi un circuit multiplicateur de tension, destiné à appliquer à la grille de T7 une tension suffisamment élevée pour provoquer sa fermeture et l'établissement du courant d'excitation même lorsque la batterie est déchargée. On utilise conventionnellement ce type de circuit dans le cas où le transistor T7 est de type "D-MOS", exigeant une tension de grille élevée pour sa fermeture.

On va maintenant décrire en référence à la figure 4 le fonctionnement du circuit de la figure 5. La figure 4 illustre, du haut vers le bas, le comportement dans le temps de la tension d'excitation Vx, du courant d'excitation effectivement consommé par le circuit (courant It traversant T7), de la tension Vr du réseau de bord et de la puissance Pd dissipée dans le circuit par commutation.

On supposera dans un premier temps que la batterie du véhicule est convenablement chargée, le cas d'une batterie déchargée étant envisagé plus loin.

On va tout d'abord considérer que la tension Vx est voisine de zéro et que le courant It est nul, le transistor T7 étant ouvert (instant t0 sur la figure 4).

Lorsque le circuit de la figure 5 reçoit à un instant t1 un signal correspondant à une demande d'accroîssement du courant d'excitation (signal de niveau bas sur E1 et tension nulle sur E2), alors T1 devient passant, tandis que T2 et T3 sont bloqués. En outre, la tension d'excitation Vx étant voisine de zéro, T6 est bloqué et T5 est passant. La diode D2 est donc polarisée en inverse et aucun courant ne peut la traverser. La grille de T7 ne peut donc être chargée que via la résistance R3. Cette résistance présente une valeur ohmique élevée, de manière que cette charge s'effectue lentement.

Le courant It augmente donc lentement, comme illustré sur la figure 4, et l'on assiste également à un lent accroissement de la tension Vx. Dès que la tension Vx a augmenté suffisamment (à l'instant t2), T6 est rendu passant, T5 est bloqué et la grille de T7 est chargée cette fois-ci non seulement via R3, mais également via la résistance R2, de valeur plus faible que R3, et donc plus rapidement. Par la suite, Vx et It restent à leur valeur maximale.

Lorsque le circuit est commandé pour réduire l'excitation de l'alternateur, c'est-à-dire que la tension à l'entrée E1 est proche du potentiel d'alimentation B+, en vue d'ouvrir T7, l'entrée E2 étant à un niveau de tension haut (instant t4), alors T1 est bloqué tandis que T2 et T3 sont rendus passants. La tension Vx ayant avant l'ouverture de T7 présenté une valeur élevée, T4 est donc passant, et la grille de T7 va pouvoir se décharger à travers R5, T4 et T3 et accessoirement à travers R4 et T2. La valeur ohmique de R5 est choisie faible de manière à ce que cette décharge ait lieu rapidement.

On observe donc à partir de l'instant t4 un abaissement rapide Vx, jusqu'à ce que sa valeur soit suffisamment faible pour que T4 se bloque. La grille de T7 ne peut donc plus se décharger que via R4, de plus forte valeur que R5, c'est-à-dire beaucoup plus lentement. Les variations de It sont donc lentes, comme illustré, à partir de t5 et jusqu'à l'instant t6 auquel ce courant devient nul.

De préférence, le rapport entre la valeur de courant faible (cas où Vx est proche de zéro) et la valeur de courant fort auxquelles est soumise la grille de T7 est de l'ordre de 1 à 10, ceci étant obtenu par un choix approprié des valeurs des résistances R2, R3, R4 et R5.

Ainsi, aussi longtemps que Vx est faible, c'est-à-dire aussi longtemps qu'une mise en ou hors de conduction de la diode de roue libre D3 est probable, le passage du courant d'excitation de T7 dans D3 ou réciproquement va se faire progressivement (période t1-t2 ou t5-t6), et donc en limitant les parasites de haute fréquence dans la tension du réseau. La figure 4 montre la très faible amplitude de ces parasites.

En revanche, dès que Vx s'est accrue suffisamment, c'est-à-dire dès que le courant circule de façon stable, des variations très rapides de cette tension deviennent possibles lors des commutations, de telle sorte qu'on peut ainsi diminuer la dissipation d'énergie lors de chaque commutation. Ainsi la figure 4 montre que la dissipation d'énergie, pendant les intervalles de temps t2-t3 ou t4-t5, est bien plus faible que dans le cas de la solution de l'art antérieur (voir figure 3), où cette dissipation d'énergie serait prolongée dans le temps à cause de la croissance lente de Vx.

On va maintenant décrire le fonctionnement du circuit dans le cas où la batterie est déchargée, avec en conséquence une tension B+ réduite. Dans ce cas, le circuit de pompe de charge applique à l'entrée E3 une tension positive destinée à assurer le maintien à l'état passant du transistor T7.

Par ailleurs, la tension B+ étant réduite, le circuit constitué par DZ3, R7 et R8 a pour effet d'abaisser la tension de grille de T5 de manière à bloquer ce dernier. En conséquence, la diode D2 ne peut plus être polarisée en inverse et la grille de T7 peut être chargée depuis l'entrée E3, à travers R1 et D2. On notera ici que la valeur de R1 est choisie suffisamment élevée pour éviter une décharge trop brutale du circuit de pompe de charge, qui serait susceptible à son tour d'engendrer des parasites dans le réseau de bord.

Ainsi, lorsque la batterie est déchargée, le circuit construit autour de T5 permet de rendre prioritaire la charge de la batterie, par maintien de T7 à l'état fermé, par rapport au fonctionnement normal du circuit de commande de courant destiné à faire varier les vitesses de charge et de décharge de la grille de T7 en fonction de la valeur de Vx.

Au contraire, lorsque la tension de batterie est normale, le circuit DZ3, R7 et R8 n'est plus capable en lui-même de bloquer T5, les commutations de ce dernier étant normalement assurées via R10 en fonction de la valeur de Vx.

On observera par ailleurs que la diode D1 a pour effet d'éviter toute fuite du courant issu de R1, D2 à travers la diode parasite inverse que constitue le transistor MOS T1.

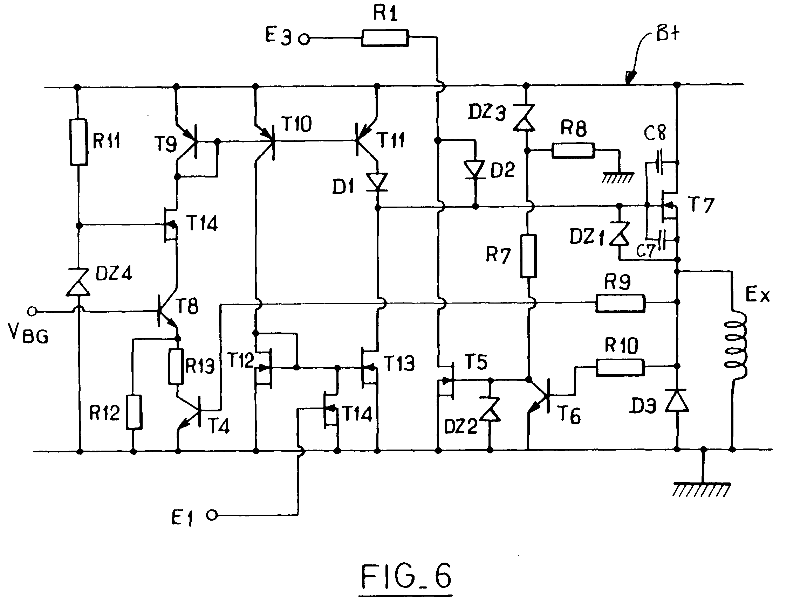

On va maintenant décrire en référence à la figure 6 une deuxième forme de réalisation de l'invention.

Dans cette variante, les résistances R1 à R5 agissant sur la grille de T7 dans le schéma de la figure 5 ont été remplacées par un circuit à miroirs de courant constitué par un ensemble de transistors T9 à T13.

Les éléments du circuit de la figure 5 qui subsistent sur la figure 6, ou des éléments ayant un rôle équivalent, sont désignés par les mêmes références.

Dans le circuit de la figure 6, un pont constitué par le montage en série d'une résistance R11 et d'une diode zéner DZ4 est monté entre la ligne B+ et la masse. Le point milieu de ce pont est appliqué à la grille d'un transistor MOS T14, dont la source est reliée au collecteur d'un transistor bipolaire NPN T8. Le drain de T14 est relié à la base et au collecteur d'un premier transistor PNP T9 d'un circuit à miroir de courant. L'émetteur de T9 est relié à la ligne B+. La base de T9 est reliée aux bases de deux autres transistors PNP T10 et T11, dont les émetteurs sont reliés à la ligne B+.

Le collecteur de T10 est relié au drain et à la grille d'un transistor MOS T12, dont la source est à la masse. Le transistor T12 forme avec un autre transistor MOS T13 un second circuit à miroir de courant, leurs grilles étant reliées entre elles et la source de T13 étant à la masse. Les grilles de T12 et T13 sont reliées au drain d'un autre transistor MOS T14, dont la source est à la masse et dont la grille est reliée à une entrée E1 pour une tension de commande d'ouverture et de fermeture de T7.

Le collecteur de T11 est relié à la grille de T7 par l'intermédiaire d'une diode D1 qui a le même rôle que la diode D1 de la figure 5.

La base de T8 reçoit une tension de référence Vbg, par exemple une tension dite de "band-gap" de 1,26 volt, obtenue de façon tout à fait classique en soi. L'émetteur de T8 est relié au collecteur de T4 par une résistance R13, et à la masse par une résistance R12. L'émetteur de T4 est relié directement à la masse, tandis que sa résistance base-émetteur R6 de la figure 5 a été supprimée, l'émetteur de T4 étant toujours relié à la masse.

Le fonctionnement du circuit de la figure 6 est le suivant.

Lorsqu'un signal de niveau haut est appliqué sur l'entrée E1, en vue de fermer T7, T14 devient passant et vient bloquer T13. Un courant provenant de T11 peut donc circuler à travers D1 en direction de la grille de T7, pour fermer celui-ci en vue d'accroître le courant d'excitation dans Ex.

Au contraire, lorsqu'un signal égal à zéro volt ou proche de zéro volt est appliqué à l'entrée E1, T14 est bloqué et T13 devient passant. Le courant provenant de T11 s'écoule alors vers la masse à travers T13, ce dernier étant bien entendu dimensionné pour être capable d'absorber tout le courant engendré par T11. T7 s'ouvre alors pour diminuer le courant d'excitation.

Lorsque la tension d'excitation Vx est voisine de zéro volt, T4 et T6 sont bloqués, et T5 est normalement passant (sauf en cas de batterie déchargée), comme dans la forme de réalisation de la figure 5, et un courant provenant du circuit de pompe de charge est dérivé vers la masse à travers T5. Dans ce cas, le circuit à miroirs de courant T9-T13 est alimenté par un courant dont la valeur est définie par la valeur ohmique de R12 et par la tension Vbg, et ce courant, selon le niveau du signal sur l'entrée E1, détermine le courant sous lequel la grille de T7 va se charger (à travers T11) ou va se décharger (à travers T13).

Au contraire, lorsque la tension Vx a suffisamment augmenté, T4 et T6 sont alors passants, alors que T5 est bloqué. Un courant issu de la pompe de charge peut alors le cas échant circuler vers la grille de T7 à travers D2. En même temps, le courant circulant dans les miroirs de courant est déterminé par la nouvelle valeur de la résistance entre T8 et la masse, constituée essentiellement par la mise en parallèle de R12 et de R13, cette dernière étant d'une valeur ohmique beaucoup plus faible que R12. Le courant de charge ou de décharge de la grille de T7 devient donc bien plus important.

Ainsi, selon l'état du signal à l'entrée E1, la grille de T7 va pouvoir se charger et se décharger de façon beaucoup plus rapide que dans le cas où Vx est proche de zéro volt, le même résultat qu'avec le circuit de la figure 5 étant donc obtenu. Dans cette réalisation également, on peut choisir un rapport entre la valeur de courant de grille faible et la valeur de courant de grille plus forte de l'ordre de 1 à 10.

Bien entendu, la présente invention n'est nullement limitée à la forme de réalisation décrite ci-dessus et représentée sur les dessins, mais l'homme de l'art saura y apporter toute variante ou modification conforme à son esprit.

En particulier, bien que l'on ait décrit ci-dessus des circuits capables d'appliquer des courants différents à la grille de T7 ou d'en soutirer des courants différents aussi bien lors des fronts montants de la tension Vx que lors de ses fronts descendants, il est clair que l'invention peut également être utilisée pour ne faire varier ces courants que lors des fronts montants ou que lors des fronts descendants.

A cet égard, on notera qu'il est en principe plus facile d'appliquer l'invention aux fronts descendants qu'aux fronts montants, car aucun problème de mise en service ou d'inhibition du circuit à pompe de charge ne se pose alors.

On notera enfin que, bien que l'invention ait été décrite en association avec un montage dans lequel l'enroulement Ex est situé entre l'interrupteur MOS T7 et la masse (régulation dite "côté haut"), elle s'applique également à des montages où l'enroulement est entre le transistor T7 et la ligne de tension positive B+ (régulation dite "côté bas"), ou encore à des montages où T7 est remplacé par une paire Darlington.

## Revendications

1. Circuit régulateur de la tension de charge d'une batterie (B) de véhicule automobile par un alternateur pourvu d'un enroulement d'excitation (Ex), une diode de roue libre (D3) étant montée en parallèle avec ledit enroulement d'excitation (Ex), le circuit régulateur comportant un élément interrupteur à semi-conducteur (T7) assujetti à des signaux de commande et un circuit de gestion des commutations de cet élément interrupteur à semi-conducteur (T7) pour alternativement établir et supprimer un courant d'excitation (It) dans l'enroulement d'excitation (Ex),lesdits signaux de commande provoquant un découpage à fréquence élevée du courant d'excitation de l'alternateur, et des moyens résistifs (R3,R12) étant prévus pour accroître les temps de montée et de descente de la tension appliquée à l'enroulement d'excitation (Ex), caractérisé en ce qu'il comprend des moyens de commande de courant (T4-T6) pour appliquer à une borne de commande dudit élément interrupteur à semi-conducteur (T7) ou pour soutirer de ladite borne de commande un faible courant donné lorsqu'une tension (Vx) aux bornes de l'enroulement d'excitation (Ex) est inférieure à une tension prédéterminée de faible valeur, de manière à obtenir des évolutions lentes du courant circulant entre les bornes d'entrée et de sortie de courant dudit élément interrupteur à semi-conducteur (T7), et pour appliquer à ladite borne de commande ou pour soutirer de ladite borne de commande un courant plus fort lorsque ladite tension aux bornes de l'enroulement d'excitation (Ex) est supérieure à ladite valeur prédéterminée.

2. Circuit selon la revendication 1, caractérisé en ce que lesdits moyens de commande de courant (T4-T6) sont mis en oeuvre seulement lors de l'ouverture ou de la fermeture dudit élément interrupteur à semi-conducteur (T7) sous l'action de signaux de commande.

3. Circuit selon la revendication 1, caractérisé en ce que lesdits moyens de commande de courant (T4-T6) sont mis en oeuvre tant lors de l'ouverture que de la fermeture dudit élément interrupteur à semi-conducteur (T7) sous l'action des signaux de commande.

4. Circuit selon l'une des revendications 1 à 3, caractérisé en ce que lesdits moyens de commande de courant comprennent un ensemble de moyens de commutation à semi-conducteurs (T4, T6) dont des bornes de commande reçoivent ladite tension aux bornes de l'enroulement d'excitation (Ex) et un ensemble de résistances (R2-R5) associées à ces moyens de commutation et capables d'être mises en série avec la borne de commande dudit interrupteur à semi-conducteur (T7).

5. Circuit selon l'une des revendications 1 à 3, caractérisé en ce que lesdits moyens de commande de courant comprennent un circuit à miroir de courant (T9-T13) incorporant une résistance (R12, R13) exposée à une tension fixe (Vbg), la valeur de ladite résistance (R12,R13) déterminant la valeur du courant circulant vers ou à partir de ladite borne de commande, et des moyens de commutation (T4) pour faire varier la valeur de ladite résistance (R12,R13) en fonction de la valeur de ladite tension aux bornes de l'enroulement d'excitation (Ex).

6. Circuit selon l'une des revendications 1 à 5, caractérisé en ce qu'il comprend en outre des moyens (T5, DZ3, R7, R8) d'inhibition au moins partielle des moyens de commande de courant lorsque la tension (Bö) aux bornes d'une batterie (B) dudit circuit électrique est faible, en vue d'appliquer audit élément interrupteur à semi-conducteur (T7) un courant au moins égal audit courant plus fort.

7. Circuit selon l'une des revendications 1 à 7 dans lequel l'élément interrupteur à semi-conducteur (T7) est un semi-conducteur de type D-MOS, caractérisé en ce qu'il comprend en outre une entrée (E3) pour un circuit à pompe de charge, en vue de solliciter la borne de commande de l'élément interrupteur à semi-conducteur (T7) sous une tension suffisante au moins pendant des périodes d'inhibition desdits moyens de commande de courant.

8. Circuit selon l'une des revendications 1 à 7, caractérisé en ce que le rapport entre la valeur du courant faible et la valeur du courant plus fort est de l'ordre de 1 à 10.

## Patentansprüche

1. Reglerschaltung für die Ladespannung zum Laden einer Kraftfahrzeugbatterie (B) durch einen Wechselstromgenerator mit einer Erregerwicklung (Ex), wobei eine Freilaufdiode (D3) parallel zu der besagten Erregerwicklung (Ex) geschaltet ist, wobei die Reglerschaltung ein Halbleiter-Schalterelement (T7), auf das Steuersignale einwirken, und eine Verwaltungsschaltung für die Schaltvorgänge dieses Halbleiter-Schalterelements (T7) umfaßt, um einen Erregerstrom (It) in der Erregerwicklung (Ex) abwechselnd ein- und auszuschalten, während die besagten Steuersignale eine in schneller Folge stattfindende Unterbrechung des Erregerstroms des Wechselstromgenerators bewirken, und wobei Widerstandsmittel (R3, R12) vorgesehen sind, um die Anstieg- und Abfallzeiten der an die Erregerwicklung (Ex) angelegten Spannung zu vergrößern, **dadurch gekennzeichnet**, daß sie Stromsteuermittel (T4-T6) umfaßt, um einen gegebenen schwachen Strom an eine Steuerklemme des besagten Halbleiter-Schalterelements (T7) anzulegen oder an dieser Steuerklemme zu entnehmen, wenn eine Spannung (Vx) an den Klemmen der Erregerwicklung (Ex) kleiner als eine vorbestimmte Spannung mit niedrigem Wert ausfällt, so daß langsame Veränderungen des zwischen den Stromeingangs- und -ausgangsklemmen des besagten Halbleiter-Schalterelements (T7) fließenden Stroms erzielt werden, und um einen stärkeren Strom an die besagte Steuerklemme anzulegen oder an der besagten Steuerklemme zu entnehmen, wenn die besagte Spannung an den Klemmen der Erregerwicklung (Ex) größer als der besagte vorbestimmte Wert ausfällt.

2. Schaltung nach Anspruch 1 , **dadurch gekennzeichnet**, daß die besagten Stromsteuermittel (T4-T6) nur beim Öffnen oder beim Schließen des besagten Halbleiter-Schalterelements (T7) unter der Einwirkung der Steuersignale eingeschaltet werden.

3. Schaltung nach Anspruch 1 , **dadurch gekennzeichnet**, daß die besagten Stromsteuermittel (T4-T6) sowohl beim Öffnen als auch beim Schließen des besagten Halbleiter-Schalterelements (T7) unter der Einwirkung der Steuersignale eingeschaltet werden.

4. Schaltung nach einem der Ansprüche 1 bis 3 , **dadurch gekennzeichnet** , daß die besagten Stromsteuermittel eine Gruppe von Halbleiter-Schaltmitteln (T4, T6), deren Steuerklemmen die besagte Spannung an den Klemmen der Erregerwicklung (Ex) erhalten, und eine Gruppe von Widerständen (R2-R5) umfassen, die diesen Schaltmitteln zugeordnet sind und mit der Steuerklemme des besagten Halbleiter-Schalterelements (T7) in Reihe geschaltet werden können.

5. Schaltung nach einem der Ansprüche 1 bis 3 , **dadurch gekennzeichnet**, daß die besagten Stromsteuermittel eine Stromspiegelschaltung (T9-T13) umfassen, die einen Widerstand (R12, R13) enthält, auf den eine feste Spannung (Vbg) einwirkt, wobei der Wert des besagten Widerstands (R12, R13) den Wert des zu bzw. von der besagten Steuerklemme aus fließenden Stroms bestimmt, und Schaltmittel (T4), um den Wert des besagten Widerstands (R12, R13) in Abhängigkeit vom Wert der besagten Spannung an den Klemmen der Erregerwicklung (Ex) zu verändern.

6. Schaltung nach einem der Ansprüche 1 bis 5 , **dadurch gekennzeichnet**, daß sie außerdem Mittel (T5, DZ3, R7, R8) für die zumindest teilweise Sperrung der Stromsteuermittel umfaßt, wenn die Spannung (B+) an den Klemmen einer Batterie (B) des besagten Stromkreises niedrig ausfällt, um an das besagte Halbleiter-Schalterelement (T7) einen Strom anzulegen, der mindestens gleich dem besagten stärkeren Strom ist.

7. Schaltung nach einem der Ansprüche 1 bis 6, bei der das Halbleiter-Schalterelement (T7) ein Halbleiter des Typs D-MOS ist, **dadurch gekennzeichnet**, daß sie außerdem einen Eingang (E3) für eine Charge-pump-Schaltung umfaßt, um die Steuerklemme des Halbleiter-Schalterelements (T7) unter einer ausreichenden Spannung mindestens während der Sperrphasen der besagten Stromsteuermittel zu beanspruchen.

8. Schaltung nach einem der Ansprüche 1 bis 7 , **dadurch gekennzeichnet**, daß das Verhältnis zwischen dem Wert des schwachen Stroms und dem Wert des stärkeren Stroms in einer Größenordnung von 1 bis 10 liegt.

## Claims

1. Circuit for regulating the charging voltage of a motor vehicle battery (B) by means of an alternator provided with an excitation winding (Ex), a freewheeling diode (D3) being connected in parallel with the said excitation winding (Ex), the regulating circuit having a semiconductor switching element (T7) subjected to control signals and a circuit for managing the switchings of this semiconductor switching element (T7) for alternately establishing and eliminating an excitation current (It) in the excitation winding (Ex), the said control signals causing a high-frequency chopping of the alternator excitation current, and resistive means (R3, R12) being provided for increasing the rise and fall times of the voltage applied to the excitation winding (Ex), characterised in that it comprises current control means (T4-T6) for applying to a control terminal of the said semiconductor switching element (T7) or for taking off from the said control terminal a given low current when a voltage (Vx) at the terminals of the excitation winding (Ex) is lower than a predetermined voltage of low value, so as to obtain slow changes in the current flowing between the current input and output terminals of the said semiconductor switching element (T7), and for applying to the said control terminal or for taking off from the said control terminal a higher current when the said voltage at the terminals of the excitation winding (Ex) is higher than the said predetermined value.

2. Circuit according to Claim 1, characterised in that the said current control means (T4-T6) are used only when the said semiconductor switching element (T7) is opened or closed under the action of control signals.

3. Circuit according to Claim 1, characterised in that the said current control means (T4-T6) are used during both the opening and the closing of the said semiconductor switching element (T7) under the action of the control signals.

4. Circuit according to one of Claims 1 to 3, characterised in that the said current control means comprise a set of semiconductor switching means (T4, T6), the control terminals of which receive the said voltage at the terminals of the excitation winding (Ex), and a set of resistors (R2-R5) associated with these switching means and capable of being put in series with the control terminal of the said semiconductor switch (T7).

5. Circuit according to one of Claims 1 to 3, characterised in that the said current control means comprise a current mirror circuit (T9-T13) incorporating a resistor (R12, R13) exposed to a fixed voltage (Vbg), the value of the said resistor (R12, R13) determining the value of the current flowing to or from the said control terminal, and switching means (T4) for varying the value of the said resistor (R12, R13) according to the value of the said voltage at the terminals of the excitation winding (Ex).

6. Circuit according to one of Claims 1 to 5, characterised in that it also comprises means (T5, DZ3, R7, R8) for at least partially inhibiting the current control means when the voltage (B+) at the terminals of a battery (B) of the said electrical circuit is low, with a view to applying to the said semiconductor switching element (T7) a current at least equal to the said higher current.

7. Circuit according to one of Claims 1 to 7, in which the semiconductor switching element (T7) is a semiconductor of the DMOS type, characterised in that it also comprises an input (E3) for a charge pump circuit, with a view to acting on the control terminal of the semiconductor switching element (T7) at a sufficient voltage at least during periods of inhibition of the said current control means.

8. Circuit according to one of Claims 1 to 7, characterised in that the ratio between the value of the low current and the value of the higher current is around 1 to 10.
